Europäisches Patentamt

European Patent Office

Office européen des brevets

(11) Veröffentlichungsnummer : **0 581 993 B1**

(12)

# EUROPÄISCHE PATENTSCHRIFT

(19)

(45) Veröffentlichungstag der Patentschrift :
**15.03.95 Patentblatt 95/11**

(21) Anmeldenummer : **92113493.8**

(22) Anmeldetag : **07.08.92**

(51) Int. Cl.$^6$ : **H02H 5/10,** H02H 1/00,
G01R 15/08, G01R 19/00

---

(54) Schaltungsanordnung zum Steuern einer Last und zum Erkennen einer Leitungsunterbrechung.

---

(43) Veröffentlichungstag der Anmeldung :
**09.02.94 Patentblatt 94/06**

(45) Bekanntmachung des Hinweises auf die
Patenterteilung :
**15.03.95 Patentblatt 95/11**

(84) Benannte Vertragsstaaten :
**DE FR GB IT**

(56) Entgegenhaltungen :
**DE-A- 3 312 304**
**DE-A- 3 907 880**

(73) Patentinhaber : **SIEMENS
AKTIENGESELLSCHAFT
Wittelsbacherplatz 2
D-80333 München (DE)
Patentinhaber : HARRIS SEMICONDUCTOR
GmbH
Putzbrunner Strasse 69
D-81739 München (DE)**

(72) Erfinder : **Allmeier, Franz, Dipl.-Ing.(FH)
St. Leonhardgasse 6a
W-8401 Mintraching (DE)**
Erfinder : **Göser, Gerhard, Dipl.-Ing.(FH)
Eichenstrasse 3c
W-8400 Regensburg (DE)**
Erfinder : **Murphy, Philip B.E.
Ohlmüllerstrasse 18
W-8000 München (DE)**
Erfinder : **Maier, Theodoor, Dipl.-Ing.
Hadamarstrasse 13a
W-8400 Regensburg (DE)**
Erfinder : **Preslar, Donald B.S.E.E.
130 Manners Rd. 357
Ringoes, NJ (DE)**

(74) Vertreter : **Fuchs, Franz-Josef, Dr.-Ing.
Postfach 22 13 17
D-80503 München (DE)**

EP 0 581 993 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Schaltungsanordnung zum Steuern einer Last und zum Erkennen einer Leitungsunterbrechung

Die Erfindung betrifft eine Schaltungsanordnung zum Steuern einer Last und zum Erkennen einer Unterbrechung der Leitung zu der Last, vorzugsweise für den Einsatz in einem Kraftfahrzeug.

Bei einer bekannten Schaltungsanordnung zum Steuern einer Last (GB-A 2 034 550), wird eine Leitungsunterbrechung zwischen der Schaltungsanordnung und der Last bei eingeschalteter Last erkannt. Hierzu wird der Spannungsabfall über die Schaltungsanordnung erfaßt und ausgewertet. Wenn trotz eingeschalteter Last infolge eines Leitungsbruchs kein Laststrom fließt, so ist der Spannungsabfall über die Schaltungsanordnung annähernd null, d.h. die Spannung ist unter einen Grenzwert gefallen und ein Fehler wird erkannt.

Allerdings ist die Spannung auch nahe null, wenn durch die Last nur ein sehr kleiner Laststrom fließt. Daher ist ein sicheres Erkennen einer Leitungsunterbrechung nicht möglich bei Schaltungsanordnungen, die sowohl bei kleinen als auch bei großen Lastströmen eingesetzt werden, d.h. bei Anwendungen mit einem großen Laststrombereich.

Die Aufgabe der Erfindung ist es, eine Schaltungsanordnung zu schaffen, die eine Unterbrechung der Leitung zu der Last bei eingeschalteter Last und über einen großen Laststrombereich zuverlässig erkennt.

Diese Aufgabe wird erfindungsgemäß durch eine Schaltungsanordnung mit den Merkmalen des Patentanspruchs 1 gelöst. Dabei wird ein Meßwiderstand in mehrere Bereiche aufgeteilt. Durch Ändern des Meßwiderstandes wird der Spannungsabfall über die Schaltungsanordnung und damit die Höhe der zu erfassenden Spannung an den Laststrom angepaßt. Deswegen ist die durch den Laststrom verursachte Verlustleistung gering.

Vorteilhafte Ausbildungen der Erfindung sind in den Unteransprüchen gekennzeichnet. Der Meßwiderstand kann durch Drain-Source-Widerstände von Feldeffekt-Transistoren realisiert werden. Eine Änderung des Meßwiderstandes erfolgt durch Ein- oder Ausschalten von einzelnen Transistoren, die parallel zueinander angeordnet sind.

Besonders vorteilhaft ist es, wenn die Drain-Source-Widerstände mit stark unterschiedlichen Widerstandswerten realisiert sind, damit sich die zu erfassende Spannung besser an den jeweiligen Laststrom anpaßt. Der Spannungsabfall über die Schaltungsanordnung ist somit gering und begrenzt nicht die für die Last verfügbare Spannung.

Damit beim Ändern des Meßwiderstandes durch Umschalten des Widerstandswertes keine Oszillation entsteht, ist eine Umschalteinrichtung vorteilhafterweise mit einer Hysterese versehen.

Die Transistoren können mit der Umschalteinrichtung thermisch gekoppelt werden, um Temperatureinflüsse infolge des Laststromflusses durch die Transistoren zu kompensieren. Hierzu ist es günstig, wenn die Schaltungsanordnung als integrierter Schaltkreis ausgebildet ist.

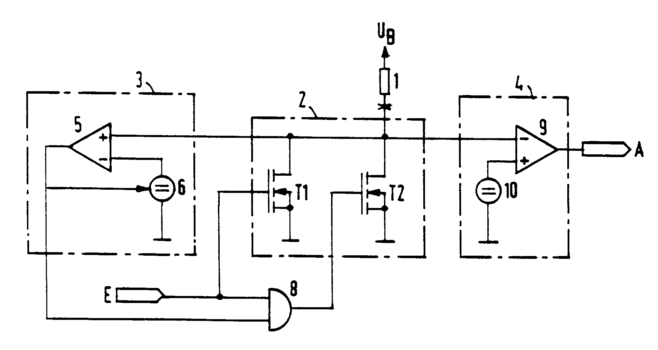

Ein Ausführungsbeispiel der Erfindung ist in der Zeichnung dargestellt und wird im folgenden näher erläutert.

Die Figur zeigt ein prinzipielles Schaltbild der erfindungsgemäßen Schaltungsanordnung.

Die in der Figur dargestellte Schaltungsanordnung kann als Treiberstufe für Motorsteuerungen bei Kraftfahrzeugen eingesetzt werden. Dabei wird eine Last 1, z.B. die Spule eines elektromagnetisch gesteuerten Einspritzventils, durch ein nicht dargestelltes Steuergerät über die Schaltungsanordnung mit ihrem Eingang E ein- oder ausgeschaltet, wobei die Schaltungsanordnung als Low-Side-Treiber eingesetzt wird. Dies bedeutet, daß die Last 1 einerseits an die Versorgungsspannung $U_B$ und andererseits an der Schaltungsanordnung, im folgenden als Treiberstufe bezeichnet, angeschlossen ist.

Die Treiberstufe weist einen Meßwiderstand 2 auf, der durch die Drain-Source-Strecken von zwei parallel angeordneten Feldeffekt-Transistoren T1 und T2 realisiert ist. Als Meßwiderstand ergibt sich der Gesamtwiderstand der Parallelschaltung der Drain-Source-Widerstände der Transistoren T1 und T2.

Die Last 1 wird durch ein Steuergerät über den Eingang E der Schaltungsanordnung ein- oder ausgeschaltet, d.h. die Gateanschlüsse der Transistoren T1 und T2 werden durch das Steuergerät gesteuert. Die Sourceanschlüsse der Transistoren T1 und T2 liegen jeweils auf Masse und die Drainanschlüsse sind mit der Last 1 verbunden.

Der Spannungsabfall über die Transistoren T1 und T2 infolge des Laststromflusses durch die Transistoren wird durch eine Umschalteinrichtung 3 und eine Diagnoseeinrichtung 4 erfaßt. Die Umschalteinrichtung 3 weist einen ersten Komparator 5 und eine erste Referenzspannungsquelle 6 auf. Die Spannung, die zwischen dem Meßwiderstand 2 und der Last 1 anliegt (im folgenden als Meßspannung bezeichnet), wird mit einer von der Referenzspannungsquelle 6 erzeugten ersten Referenzspannung (Schwellwert S1) verglichen. Das Ausgangssignal des Komparators 5 steuert sowohl die Referenzspannungsquelle 6 und stellt somit den Schwellwert S1 ein als auch ein UND-Gatter 8, das wiederum den Transistor T2 ein- oder ausschaltet.

Die Diagnoseeinrichtung 4 weist einen zweiten Komparator 9 und eine zweite Referenzspannungsquelle 10 auf. Die Meßspannung wird mit einer von der Referenzspannungsquelle 10 erzeugten zweiten Referenzspannung (Schwellwert S2) verglichen. Bei einer Unterbrechung der Leitung zu der Last 1 (in der Figur durch ein Kreuz gekennzeichnet) wird am Ausgang A der Schaltungsanordnung ein Diagnosesignal ausgegeben.

Das Steuern von Spannungsquellen ist von der Elektronik her hinreichend bekannt (z.B. Tietze, Schenk "Halbleiter-Schaltungstechnik", gesteuerte Quellen mit Stromspiegel) und wird daher nicht näher beschrieben.

Die Schaltungsanordnung zum Erkennen einer Leitungsunterbrechung funktioniert nach dem Prinzip einer Strommessung mit einem Shunt. Bei eingeschalteter Treiberstufe wird diejenige Spannung, die sich über den Meßwiderstand 2 infolge des Stromflusses durch die Last 1 einstellt, erfaßt und mit den Schwellwerten S1, S2 verglichen. Diese Spannung wird im folgenden als Meßspannung bezeichnet.

Um eine Leitungsunterbrechung über einen großen Laststrombereich sicher erkennen zu können, wird der Meßwiderstand 2 in mehrere Widerstandsbereiche aufgeteilt, d.h. in Abhängigkeit von dem Laststrom wird der Widerstandswert so geändert, daß sich ein genügend großer Spannungsabfall sowohl bei einem kleinen als auch bei einem großen Laststrom über den Meßwiderstand ergibt.

Bei dem vorliegenden Ausführungsbeispiel können zwei verschiedene Widerstandswerte des Meßwiderstands 2 eingestellt werden. Hierzu ist der Meßwiderstand 2 so ausgebildet, daß sein Widerstandswert bei einem kleinen Laststrom viel größer ist, als bei einem großen Laststrom. Die sich einstellende Meßspannung wird mit den zwei Schwellwerten S1 und S2 verglichen, wobei gilt:

$$U_B > S1 > S2 > 0\ V$$

Die Änderung des Meßwiderstands 2 wird durch die Umschalteinrichtung 3 gesteuert, und zwar dann, wenn die Meßspannung den ersten Schwellwert S1 unterschreitet, z.B. bei einem kleinen Laststrom, der einen kleinen Spannungsabfall über den Meßwiderstand 2 erzeugt hat. Der Meßwiderstand wird von einem kleinen Wert auf einen großen umgeschaltet, indem der Transistor T2 gesperrt wird. Die Meßspannung bleibt größer als der Schwellwert S2.

Als Nebeneffekt erhöht sich die Meßspannung wieder und wäre nun größer als der Schwellwert S1, wenn mit der Widerstandsänderung der Schwellwert S1 nicht erhöht worden wäre. Dies hätte sonst eine Oszillation der Schaltungsanordnung zur Folge hat. Diese Eigenschaft der Umschalteinrichtung 3 kann auch als Hysterese bezeichnet werden. Hierfür wird der erste Schwellwert S1, der durch die erste Referenzspannungsquelle 6 bestimmt wird, erhöht.

Bei einer nicht beabsichtigten Unterbrechung der Leitung zu der Last 1 fließt nur noch ein sehr geringer Reststrom, der nur durch Eingangsströme der Komparatoren 6 und 9 bedingt ist, durch den Meßwiderstand 2. Die Meßspannung ist daher annähernd 0 V. Der zweite Schwellwert S2, der durch die zweite Referenzspannungsquelle 10 bestimmt wird, ist so bemessen, daß er dann sicher über dieser Meßspannung liegt, aber kleiner ist als die Meßspannung, die sich bei einem kleinen Laststrom einstellt. Wenn die Meßspannung kleiner als der Schwellwert S2 ist, wird ein Diagnosesignal in der Diagnoseeinrichtung 4 erzeugt, das über den Ausgang A zu einer nicht dargestellten Auswerteeinheit gesendet wird.

Wenn der Meßwiderstand 2 durch Feldeffekt-Transistoren T1 und T2 realisiert ist, wird der Meßwiderstandswert durch den Drain-Source-Widerstand der Transistoren T1 und T2 bestimmt. Besonders vorteilhaft ist es, die Drain-Source-Widerstandswerte stark unterschiedlich auszubilden, damit die Schaltungsanordnung bei Anwendungen mit einem großen Laststrombereich eingesetzt werden kann.

Der erste Transistor T1 hat einen Drain-Source-Widerstandswert im leitenden Zustand von etwa 3 Ω und der zweite Transistor T2 von etwa 0,3 Ω. Bei großen Lastströmen wird der wirksame Widerstandswert durch die Parallelschaltung der Transistoren T1 und T2 bestimmt, er ist also etwa 0,27 Ω, und bei kleinen Lastströmen nur durch den Transistor T1 mit etwa 3 Ω, da der Transistor T2 gesperrt ist und dann einen sehr großen Drain-Source-Widerstand hat.

Im Ruhezustand, d.h. wenn kein Laststrom fließen soll, sind beide Transistoren T1 und T2 gesperrt. Wenn ein Laststrom fließ, sind beide Transistoren T1 und T2 zunächst leitend und der Laststrom verteilt sich auf sie entsprechend ihrem Drain-Source-Widerstand. Wenn der Laststrom jedoch eine gewisse Größe unterschreitet, wird die Meßspannung kleiner als der Schwellwert S1. Folglich wird über den Ausgang des Komparators 5 und das UND-Gatter 8 der Transistor T2 gesperrt, während der Transistor T1 weiterhin leitet.

Die Schaltungsanordnung kann als integrierter Schaltkreis (IC) ausgebildet sein. In einem solchen IC können die unterschiedlichen Drain-Source-Widerstandswerte beispielsweise durch unterschiedlich große Transistorflächen realisiert werden.

In einem IC ist es auch vorteilhaft, eine durch Temperaturänderung der Transistoren T1 und T2 verursachte Drift der Meßspannung dadurch zu kompensieren, daß die erste Referenzspannungsquelle 6 in die Nähe der Transistoren T1 und T2 plaziert wird, damit der Schwellwert auch eine Temperaturdrift in gleicher Richtung erfährt.

Besonders vorteilhaft ist es, als Transistoren T1 und T2 D-MOSFET-Transistoren einzusetzen. Es können auch mehr als zwei Transistoren parallel angeordnet werden. Dies entspricht dann einem Meßwiderstand 2 mit mehreren Widerstandsstufen, die in Abhängigkeit von dem Laststrom eingeschaltet werden können.

Bei einem weiteren, nicht dargestellten Ausführungsbeispiel (Elemente gleicher Funktion tragen dieselben Bezeichnungen wie im ersten Ausführungsbeispiel) ist die Umschalteinrichtung zusammen mit dem UND-Gatter durch eine Regeleinrichtung ersetzt. Dabei wird der Meßwiderstand nicht stufenweise geschaltet, sondern kontinuierlich geregelt. Durch die Regeleinrichtung wird über die Spannung an den Gateanschlüssen der Transistoren T1 und T2 die Meßspannung auf einen konstanten Wert geregelt.

**Patentansprüche**

1. Schaltungsanordnung zum Steuern einer Last (1) und zum Erkennen einer Unterbrechung der Leitung zu der Last, **dadurch gekennzeichnet, daß** sie einen Meßwiderstand (2), der in Reihe zu der Last (1) angeordnet ist und dessen Widerstandswert in Abhängigkeit von dem Laststrom durch eine Umschalteinrichtung (3) geändert wird, sowie eine Diagnoseeinrichtung (4) aufweist, die ein Diagnosesignal erzeugt, wenn der durch den Laststrom hervorgerufenen Spannungsabfall über den Meßwiderstand (2) einen Schwellwert unterschreitet.

2. Schaltungsanordnung nach Anspruch 1, dadurch gekennzeichnet, daß der Meßwiderstand (2) mindestens zwei parallel angeordnete Feldeffekt-Transistoren (T1, T2) aufweist und sein Widerstandswert durch die Drain-Source-Strecke der Transistoren bestimmt wird.

3. Schaltungsanordnung nach Anspruch 2, dadurch gekennzeichnet, daß die Transistoren (T1, T2) unterschiedliche Drain-Source-Widerstandswerte im leitenden Zustand aufweisen.

4. Schaltungsanordnung nach Anspruch 3, dadurch gekennzeichnet, daß die Umschalteinrichtung (3) als hysteresebehafteter Komparator (5) ausgebildet ist, an dessen ersten Eingang die Drain-Source-Spannung und an dessen zweiten Eingang eine erste Referenzspannung anliegt.

5. Schaltungsanordnung nach Anspruch 4, dadurch gekennzeichnet, daß einer der Transistoren (T1) thermisch mit der ersten Referenzspannungsquelle (6) gekoppelt ist, um eine Temperaturdrift der Meßspannung zu kompensieren, die durch eine Erwärmung des Transistors infolge des Stromflusses durch den Transistor hervorgerufen wird.

6. Schaltungsanordnung nach Anspruch 3, dadurch gekennzeichnet, daß die Diagnoseeinrichtung (4) als Komparator (9) ausgebildet ist, an dessen ersten Eingang die Drain-Source-Spannung und an dessen zweiten Eingang eine zweite Referenzspannung anliegt.

7. Schaltungsanordnung nach Anspruch 1, dadurch gekennzeichnet, daß sie als integrierter Schaltkreis ausgebildet ist.

**Claims**

1. Circuit arrangement for controlling a load (1) and for detecting an interruption in the line to the load, characterized in that it has a precision resistor (2), which is connected in series to the load (1) and whose resistance value is changed by a change-over device (3) as a function of the load current, and a diagnostic device (4) which generates a diagnostic signal when the voltage drop across the precision resistor (2), caused by the load current, falls below a threshold value.

2. Circuit arrangement according to Claim 1, characterized in that the precision resistor (2) has at least two field effect transistors (T1, T2) arranged in parallel and its resistance value is determined by the drain-source junction of the transistors.

3. Circuit arrangement according to Claim 2, characterized in that the transistors (T1, T2) have in the conductive state different drain-source resistance values.

4. Circuit arrangement according to Claim 3, characterized in that the change-over device (3) is designed as hysteresis-subjected comparator (5), on whose first input the drain-source voltage and on whose second input a first reference voltage is present.

5. Circuit arrangement according to Claim 4, characterized in that one of the transistors (T1) is thermally coupled to the first reference voltage source (6) for the purpose of compensating a temperature drift of the measuring voltage which is caused by the transistor being heated due to the current flow through the transistor.

6. Circuit arrangement according to Claim 3, characterized in that the diagnostic device (4) is designed as comparator (9), on whose first input the drain-source voltage and on whose second input a second reference voltage is present.

7. Circuit arrangement according to Claim 1, characterized in that it is designed as an integrated circuit.

**Revendications**

1. Montage pour la commande d'une charge (1) et pour l'identification d'une interruption de la ligne raccordée à la charge, caractérisé par le fait qu'il possède une résistance de mesure (2), disposée en série avec la charge (1) et dont la valeur résistive est modifiée en fonction du courant de charge par un dispositif de commutation (3), ainsi qu'un dispositif de diagnostic (4), qui produit un signal de diagnostic lorsque la chute de tension provoquée par le courant de charge aux bornes de la résistance de mesure (2) tombe au-dessous d'une valeur de seuil.

2. Montage suivant la revendication 1, caractérisé par le fait que la résistance de mesure (2) comporte au moins deux transistors à effet de champ (T1,T2) branchés en parallèle et que sa valeur résistive est déterminée par la voie drain-source de ce transistor.

3. Montage suivant la revendication 2, caractérisé par le fait que les transistors (T1,T2) possèdent des valeurs résistives drain-source différentes à l'état conducteur.

4. Montage suivant la revendication 3, caractérisé par le fait que le dispositif de commutation (3) est réalisé sous la forme d'un comparateur (5) affecté d'une hystérèse, à la première entrée duquel est appliquée la tension drain-source et à la seconde entrée duquel est appliquée une première tension de référence.

5. Montage suivant la revendication 4, caractérisé par le fait que l'un des transistors (T1) est couplé thermiquement à la première source de tension de référence (6), de manière à compenser une dérive de température de la tension de mesure, qui est provoquée par un échauffement du transistor en raison du flux de courant traversant le transistor.

6. Montage suivant la revendication 3, caractérisé par le fait que le dispositif de diagnostic (4) est réalisé sous la forme d'un comparateur (9), à la première entrée duquel est appliquée la tension drain-source et à la seconde entrée duquel est appliquée une seconde tension de référence.

7. Montage suivant la revendication 1, caractérisé par le fait qu'il est réalisé sous la forme d'un circuit intégré.